(19) Europäisches Patentamt
European Patent Office
Office européen des brevets

(11) **EP 1 157 468 B1**

(12) **EUROPÄISCHE PATENTSCHRIFT**

(45) Veröffentlichungstag und Bekanntmachung des Hinweises auf die Patenterteilung:
**24.05.2006 Patentblatt 2006/21**

(21) Anmeldenummer: **00916776.8**

(22) Anmeldetag: **01.03.2000**

(51) Int Cl.:
*H03K 21/00* (2006.01)     *H03K 21/40* (2006.01)

(86) Internationale Anmeldenummer:
**PCT/DE2000/000593**

(87) Internationale Veröffentlichungsnummer:
**WO 2000/052827 (08.09.2000 Gazette 2000/36)**

(54) **ANORDNUNG UND VERFAHREN ZUM ERMITTELN, OB DER ZÄHLSTAND EINES ZÄHLERS EINEN VORBESTIMMTEN ZÄHLSTAND ERREICHT HAT ODER NICHT**

SYSTEM AND METHOD FOR DETECTING WHETHER THE COUNT OF A COUNTER HAS REACHED A PREDETERMINED COUNT OR NOT

SYSTEME ET PROCEDE POUR DETERMINER SI LA VALEUR DE COMPTAGE D'UN COMPTEUR A ATTEINT OU NON UNE VALEUR DE COMPTAGE PREDEFINIE

(84) Benannte Vertragsstaaten:
**DE FR GB IT**

(30) Priorität: **01.03.1999 DE 19908807**

(43) Veröffentlichungstag der Anmeldung:
**28.11.2001 Patentblatt 2001/48**

(60) Teilanmeldung:
**05111666.3 / 1 630 963**

(73) Patentinhaber: **Infineon Technologies AG
81669 München (DE)**

(72) Erfinder:
• **ROHM, Peter
D-85276 Pfaffenhofen (DE)**

• **LETEINTURIER, Patrick
D-81739 München (DE)**

(74) Vertreter: **Jannig, Peter et al
Jannig & Repkow,
Patentanwälte,
Klausenberg 20
86199 Augsburg (DE)**

(56) Entgegenhaltungen:
**US-A- 5 666 329**

• **WEXLER S.B.: 'Selection Using Cascaded Counters' IBM TECHNICAL DISCLOSURE BULLETIN Bd. 8, Nr. 3, August 1965, Seiten 370 - 371**
• **SCHRÜFER E.: 'Elektrische Messtechnik', 1983, CARL HANSER VERLAG, MÜNCHEN, WIEN**

EP 1 157 468 B1

**EP 1 157 468 B1**

**Beschreibung**

Anordnung und Verfahren zum Ermitteln, ob der Zählstand eines Zählers einen vorbestimmten Zählstand erreicht hat oder nicht.

Die vorliegende Erfindung betrifft eine Vorrichtung gemäß dem Oberbegriff des Patentanspruchs 1 und ein Verfahren gemäß dem Oberbegriff des Patentanspruchs 6, d.h. eine Anordnung und ein Verfahren zum Ermitteln, ob der Zählstand eines Zählers einen vorbestimmten Zählstand erreicht hat oder nicht.

Entsprechender Stand der Technik ist bekannt aus der Veröffentlichung S.B. WEXLER: "Selection Using Cascaded Counters" IBM TECHNICAL DISCLOSURE BULLETIN, August 1965, Band 8, Nr. 3, Seiten 370 - 371.

Zur Ermittlung, ob der Zählstand eines Zählers einen vorbestimmten Zählstand erreicht hat, wird üblicherweise ein Gleich-Vergleicher verwendet, durch den die Zählstände des Zählers jeweils mit dem vorbestimmten Zählstand verglichen werden.

Das Erreichen eines bestimmten Zählstandes ist in Steuer- und Regeleinrichtungen häufig das auslösende Ereignis für die Erzeugung eines Impulses oder eine Flanke. Derartige Steuer- und Regeleinrichtungen sind seit vielen Jahren in unzähligen Ausführungsformen bekannt und bedürfen keiner näheren Erläuterung.

Die Erfahrung zeigt allerdings, daß ereignisgesteuerte Impuls- oder Flankenerzeugungen dieser Art entweder nur mit relativ großem Aufwand oder überhaupt nicht oder jedenfalls nicht unter allen Umständen exakt an die individuellen Bedürfnisse anpaßbar sind.

Der vorliegenden Erfindung liegt daher die Aufgabe zugrunde, die Anordnung und das Verfahren gemäß den Oberbegriffen der Patentansprüche 1 und 6 derart weiterzubilden, daß diese mit minimalem Aufwand eine jederzeit individuell an verschiedene Bedürfnisse anpaßbare Impuls- oder Flankenerzeugung ermöglicht.

Diese Aufgabe wird erfindungsgemäß durch die im kennzeichnenden Teil des Patentanspruchs 1 (Vorrichtung) bzw. die im kennzeichnenden Teil des Patentanspruchs 6 (Verfahren) beanspruchten Merkmale gelöst.

Demnach zeichnen sich die erfindungsgemäße Anordnung und das erfindungsgemäße Verfahren dadurch aus, daß bei der Ermittlung bzw. der diese ausführenden Anordnung die Differenz zwischen dem Zählstand und dem vorbestimmten Zählstand mit einem ersten Wert oder einem negativen zweiten Wert verglichen wird, wobei die Differenz mit dem ersten Wert verglichen wird, wenn die Differenz größer oder gleich 0 ist, und wobei die Differenz mit dem zweiten Wert verglichen wird, wenn die Differenz kleiner 0 ist, und signalisiert wird, daß der Zähler den vorbestimmten Zählstand erreicht hat, wenn die Differenz kleiner ist als der erste Wert bzw. kleiner ist als der zweite Wert und ansonsten signalisiert wird, daß der Zähler den vorbestimmten Zählstand nicht erreicht hat, wobei der vorbestimmte Zählstand und/oder der erste Wert und/oder der zweite Wert variierbar sind.

Durch eine derartige Konfigurierbarkeit der Ermittlung bzw. der diese ausführenden Anordnung sind diese jederzeit äußerst einfach und flexibel an unterschiedlichste Bedürfnisse anpaßbar. Aus den bislang überhaupt nicht oder nur beschrankt individuell anpaßbaren Anordnungen und Verfahren zum Ermitteln, ob der Zählstand eines Zählers einen vorbestimmten Zählstand erreicht hat oder nicht, werden dadurch nahezu universell einsetzbare und auch an wechselnde Bedürfnisse sofort anpaßbare Anordnungen und Verfahren.

Vorteilhafte Weiterbildungen der Erfindung sind den abhängigen Ansprüchen, der nachfolgenden Beschreibung und den Figuren entnehmbar.

Die Erfindung wird nachfolgend anhand von Ausführungsbeispielen unter Bezugnahme auf die Figuren näher erläutert. Es zeigen

Figur 1            eine graphische Darstellung zur Veranschaulichung des Zählverhaltens eines Zählers, für dessen Zählstand durch die vorliegend näher betrachtete Anordnung und das vorliegend näher betrachtete Verfahren ermittelbar sein soll, ob er einen vorbestimmten Zählstand schon erreicht hat oder nicht,

Figuren 2A bis 2C   graphische Darstellungen zur Veranschaulichung möglicher Lagen eines bei der Ermittlung zu berücksichtigenden Zeitfensters,

Figur 3            ein Blockschaltbild einer erfindungsgemäßen Anordnung zum Ermitteln, ob ein Zählstand eines Zählers innerhalb eines größen- und/oder lagemäßig variierbaren Zeitfensters einen vorbestimmten Zählstand schon erreicht hat oder nicht,

Figur 4            ein Blockschaltbild einer Anordnung, deren Funktion und Wirkungsweise für den Fall, daß die Größe des vor dem vorbestimmten Zählstand liegende Teils des Zeitfensters gleich der Größe des nach dem vorbestimmten Zählstand liegenden Teils des Zeitfensters ist, der Anordnung gemäß Figur 3, entspricht,

Figur 5            ein Blockschaltbild einer Anordnung, deren Funktion und Wirkungsweise für den Fall, daß die Größe des vor dem vorbestimmten Zählstand liegenden Teils des Zeitfensters um einen Zähltakt kürzer ist als die Größe des nach dem vorbestimmten Zählstand liegenden Teils des Zeitfensters ist, der Anordnung gemäß Figur 3 entspricht,

Figur 6        ein Blockschaltbild einer nicht beanspruchten Anordnung, bei welcher bei der Ermittlung, ob ein Zählstand eines Zählers einen vorbestimmten Zählstand erreicht hat oder nicht, nur ausgewählte Bits der Zählstände berücksichtigt werden, und

Figur 7        den Aufbau eines Carry-Bit-Erzeugungsblocks C und eines (Ermittlungs-)Resultat-Erzeugungsblocks R gemäß Figur 6.

Die nachfolgend näher betrachteten Anordnungen ermitteln, ob der Zählstand eines Zählers innerhalb eines zu berücksichtigenden Zeitfensters einen vorbestimmten Zählstand erreicht hat oder nicht.

Die Anordnung ist vorzugsweise in dem Zähler, dessen Zählstand sie mit dem vorbestimmten Zählstand vergleichen soll, oder in unmittelbarer Nähe desselben vorgesehen. Dadurch kann auf einfache Weise und mit geringem Aufwand erreicht werden, daß dem durchzuführenden Vergleich jeweils der aktuelle Zählstand des Zählers zugrundegelegt wird; wenn der Zählstand des Zählers beispielsweise über einen Bus zu der diesen auswertenden Anordnung übertragen werden muß, ist dies normalerweise nicht der Fall. Allerdings besteht auf eine solche Positionierung der Anordnung keine Einschränkung. Die Anordnung kann grundsätzlich an beliebigen Stellen vorgesehen werden.

Die beschriebenen Anordnungen zeichnen sich dadurch aus, daß sie durch größen- und/oder lagemäßiges Variieren des bei der Ermittlung zu berücksichtigenden Zeitfensters und/oder durch Variieren der bei der Ermittlung zu berücksichtigenden Bits der zu vergleichenden Zählstände konfigurierbar ist.

Zur Konfigurierung der Ermittlung, ob der Zählstand des Zählers innerhalb eines zu berücksichtigenden Zeitfensters einen vorbestimmten Zählstand erreicht hat oder nicht, werden nachfolgend zwei Möglichkeiten vorgestellt, die wahlweise einzeln oder in Kombination verwendet werden können.

Den beiden Varianten ist gemeinsam,

- daß bei der Ermittlung nur ein wenigstens größenmäßig variierbares Zeitfenster berücksichtigt wird, und

- daß nicht nur ermittelt wird, ob der aktuelle Zählstand des Zählers mit dem vorbestimmten Zählstand übereinstimmt, sondern auch, ob der Zählstand des Zählers innerhalb des verstrichenen Teils des zu berücksichtigenden Zeitfensters den vorbestimmten Zählstand passiert hat.

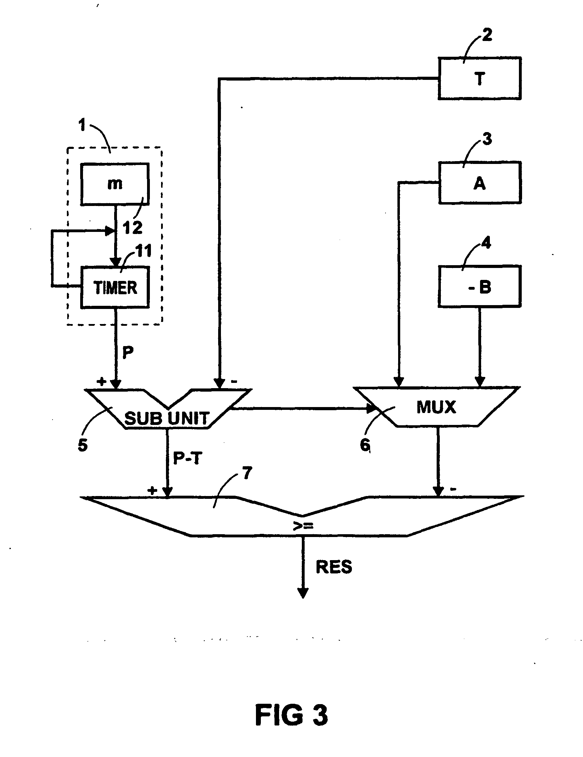

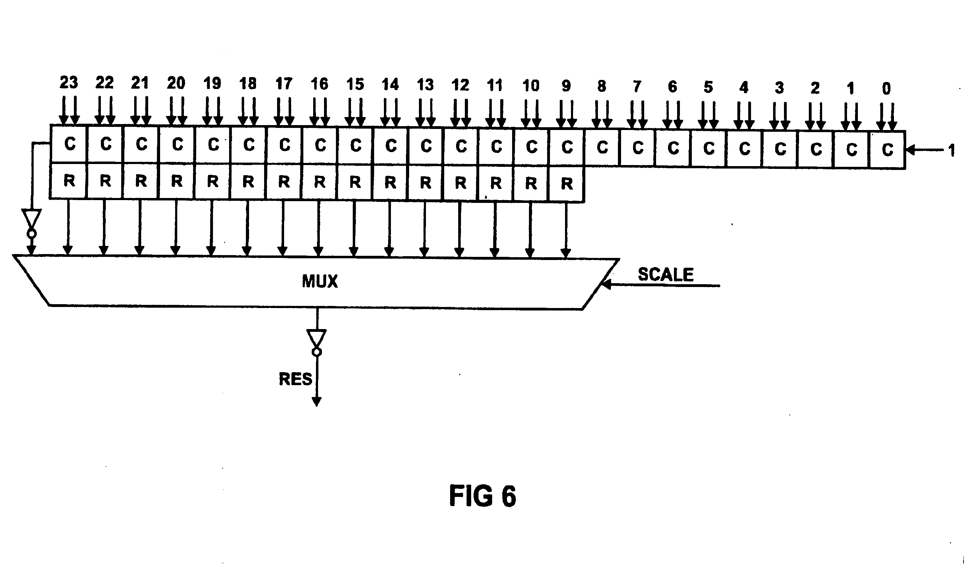

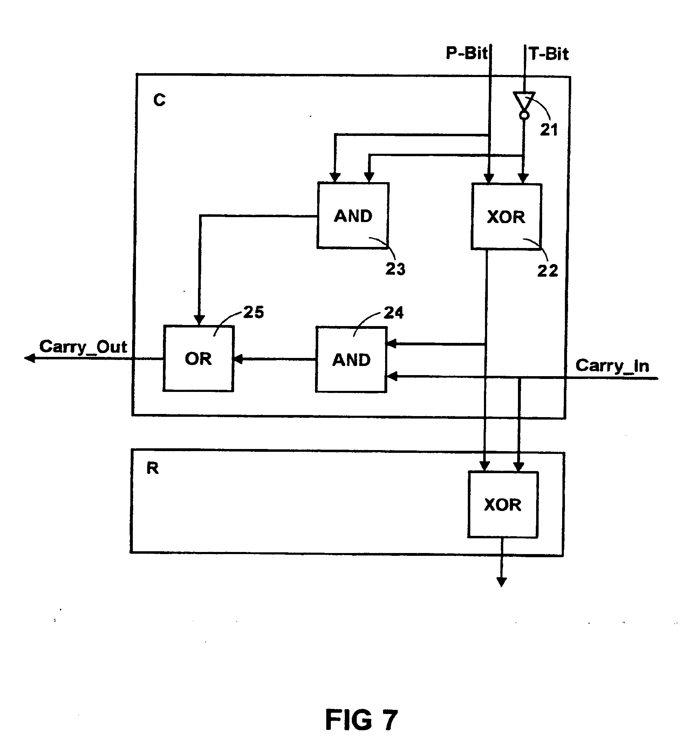

Die erste der genannten Varianten wird nachfolgend, als erfindungsgemäße Ausführungsform, unter besonderer Bezugnahme auf die Figuren 3 bis 5, und die zweite Variante unter besonderer Bezugnahme auf die Figuren 6 und 7 beschrieben.

Bei der ersten, erfindungsgemäßen Variante wird bei der Ermittlung, ob der Zählstand des Zählers den vorbestimmten Zählstand erreicht hat oder nicht, nur ein bestimmtes Zeitfenster berücksichtigt, welches sowohl größenmäßig als auch lagemäßig variierbar ist. Das Zeitfenster wird im betrachteten Beispiel relativ zum vorbestimmten Zählstand, welcher nachfolgend als Threshold- oder Schwellenwert T bezeichnet wird, definiert (um diesen herum definiert). Es sei bereits an dieser Stelle darauf hingewiesen, daß das zu berücksichtigende Zeitfenster auch um beliebige andere Bezugspunkte definiert werden kann.

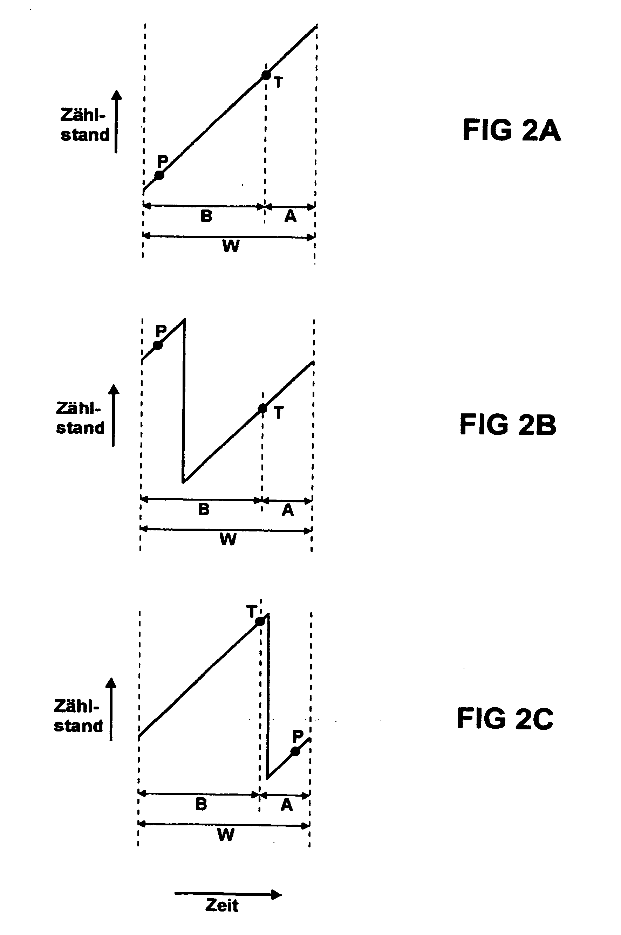

Das zu berücksichtigte Zeitfenster ist in den Figuren mit dem Bezugszeichen W bezeichnet und erstreckt sich im betrachteten Beispiel vom Erreichen eines Zählstandes T - B bis zum Erreichen eines Zählstandes T + A (siehe Figur 2A).

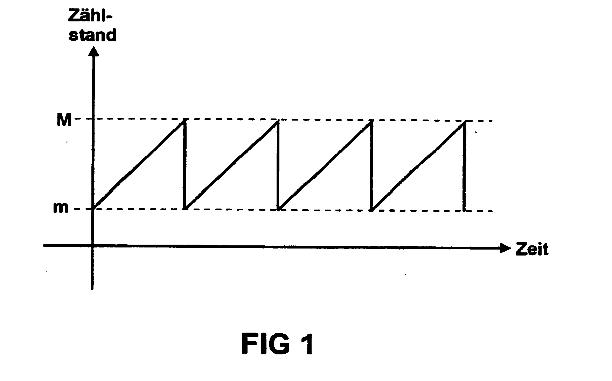

Zählt der Zähler wiederholt (periodisch) von einem Zählstand m bis zu einem Zählstand M (siehe Figur 1), so sollte gelten: $M - m \geq A + B$. Die Werte A und B sind ansonsten grundsätzlich frei wählbar. Insbesondere ist es nicht erforderlich, daß T-B = m und/oder T + A = M gilt (siehe Figuren 2B und 2C).

Eine Anordnung, die eine größen- und lagemäßige Variierung des zu berücksichtigenden Zeitfensters gestattet, und die in der Lage ist, zu ermitteln, ob der Zählstand des Zählers innerhalb des zu berücksichtigenden Zeitfensters den vorbestimmten Zählstand (den Threshold-Wert T) erreicht oder passiert hat oder nicht, ist in Figur 3 dargestellt.

Wie aus der Figur 3 ersichtlich ist, umfaßt diese Anordnung eine Zähleinheit 1, Speichereinrichtungen 2, 3 und 4 zur Speicherung des Threshold-Wertes T und der die Größe und die Lage des zu berücksichtigenden Zeitfensters definierenden Werte A und B (genauer gesagt des Wertes A und des negierten Wertes B), einen (Voll-) Subtrahierer 5, einen Multiplexer 6 und einen Größer/Gleich-Vergleicher 7, wobei die Zähleinheit 1 einen Zähler (timer) 11 und eine Speichereinrichtung 12 zur Speicherung eines Zählstandes (m), an welchem der Zähler 11 jeweils mit dem Zählen beginnen soll.

Der Zähler 11, genauer gesagt dessen im folgenden.mit dem Bezugszeichen P bezeichneter Zählstand ist bei Bedarf (beispielsweise bei einem wie in Figur 1 gezeigten Zählen des Zählers 11) auf den in der Speichereinrichtung 12 gespeicherten Wert zurücksetzbar..

Die Speichereinrichtung 12 und die Speichereinrichtungen 2, 3, und 4 sind vorzugsweise wiederbeschreibbare Speichereinrichtungen mit veränderbarem Inhalt.

Der Zählstand P des Zählers 11 und der in der Speichereinrichtung 2 gespeicherte Threshold-Wert T werden dem Subtrahierer 5 zugeführt. Dieser bildet die Differenz P - T, gibt diese an den Größer/Gleich-Vergleicher 7 aus und steuert abhängig vom Vorzeichen der Differenz den Multiplexer 6 an.

Dem Multiplexer 6 werden der in der Speichereinrichtung 3 gespeicherte Wert A und der in der Speichereinrichtung 4 gespeicherte Wert -B zugeführt. Der Multiplexer 6 wird, wie vorstehend bereits erwähnt wurde, durch den Subtrahierer 5 angesteuert, und zwar derart, daß der Multiplexer 6 den Wert A ausgibt; wenn das Ergebnis der vom Subtrahierer 5 ausgeführten Subtraktion P - T größer oder gleich null ist, und daß der Multiplexer 6 den Wert -B durchschaltet, wenn die Differenz P - T kleiner als null ist. Das vom Multiplexer 6 durchgeschaltete Signal wird als zweites Signal an den Größer/Gleich-Vergleicher 7 angelegt.

Der Größer/Gleich-Vergleicher 7 überprüft, ob der vom Subtrahierer 5 ausgegebene Wert größer ist als oder gleich groß ist wie der vom Multiplexer 6 durchgeschaltete Wert oder nicht und gibt ein das Vergleichsergebnis repräsentierendes Signal RES aus.

Das das Vergleichsergebnis repräsentierende Signal RES ist zugleich das das Ergebnis der durchzuführenden Ermittlung repräsentierende Signal.

Signalisiert das Signal RES, daß der vom Subtrahierer 5 ausgegebene Wert größer als oder gleich groß wie der vom Multiplexer 6 durchgeschaltete Wert ist, so hat der Zählstand P des Zählers 11 den Threshold-Wert T innerhalb des aktuellen Zeitfensters noch nicht erreicht oder passiert; der dies signalisierende Zustand des Signals RES wird nachfolgend als "EREIGNIS NICHT EINGETRETEN" bezeichnet. Anderenfalls hat der Zählstand P des Zählers 11 den Threshold-Wert T innerhalb des betreffenden Zeitfensters bereits erreicht oder passiert; der dies signalisierende Zustand des Signals RES wird nachfolgend als "EREIGNIS EINGETRETEN" bezeichnet.

Die Funktion der Anordnung gemäß Figur 3 läßt sich mathematisch wie folgt ausdrücken:

1)

$$\text{Delta} = P - T$$

2)

$$ZE = \text{Delta} - A \quad (\text{für Delta} \geq 0)$$

bzw.

$$ZE = \text{Delta} + B \quad (\text{für Delta} < 0)$$

3) RES signalisiert "EREIGNIS EINGETRETEN" (für ZE < 0)
bzw.
RES signalisiert "EREIGNIS NICHT EINGETRETEN" (für ZE ≥ 0)

Hieraus (genauer gesagt aus Schritt 2) läßt sich ersehen, daß die Ermittlung, ob der Zählstand P des Zählers 11 innerhalb des zu berücksichtigenden Zeitfensters den Threshold-Wert T erreicht oder überschritten hat, auch dann richtig durchgeführt wird, wenn - wie in Figur 2B und 2C dargestellt - der Zählstand P des Zählers 11 innerhalb des zu berücksichtigenden Zeitfensters einen Rücksprung von M auf m durchführt.

Daß durch die Anordnung gemäß Figur 3 nicht nur ermittelt wird, ob der Zählstand P des Zählers 11 zum betreffenden Zeitpunkt gleich dem Threshold-Wert T ist, sondern .zusätzlich überprüft wird, ob der Zählstand P des Zählers 11 den Threshold-Wert T innerhalb des zu berücksichtigenden Zeitfensters passiert hat, erweist sich insbesondere bei Veränderungen des Threshold-Wertes T von Vorteil. Dadurch kann erreicht werden, daß die Akti.on, die bei Erreichen des Threshold-Wertes T durch den Zählstand P des Zählers 11 auszuführen ist, in Fällen, in denen der Threshold-Wert T nach einer Änderung desselben einen Zählstand repräsentiert, der innerhalb des momentanen Zeitfensters vom Zählstand P des Zählers 11 bereits passiert wurde, im betreffenden Zeitfenster nicht ausgelassen, sondern sofort ausgeführt, also innerhalb des betreffenden Zeitfensters quasi nachgeholt wird.

Dabei ist durch die Werte A und B einstellbar, mit welcher maximalen Zeitverzögerung gegenüber dem Normalfall die Aktion noch ausgeführt werden darf. Eine eigentlich bei Erreichen des Threshold-Wertes T durch den Zählstand P des Zählers 11 auszuführende Aktion wird bei der Anordnung gemäß Figur 3 noch bis zu A Zähltakte nach dem Erreichen des Threshold-Wertes T durch den Zählstand P des Zählers 11 ausgeführt; liegt das Erreichen des Threshold-Wertes T durch den Zählstand P des Zählers um mehr als A Zähltakte zurück, so wird die Aktion erst ausgeführt, wenn der Zählstand P des Zählers 11 den Threshold-Wert T das nächste Mal erreicht.

Die in der Figur 3 gezeigte Anordnung ist trotz deren sehr einfachen Aufbaus sehr flexibel einsetzbar und mit minimalem Aufwand jederzeit hervorragend an individuelle und/oder wechselnde Bedürfnisse anpaßbar.

Die Anordnung gemäß Figur 3 läßt sich unter gewissen Voraussetzungen noch weiter vereinfachen.

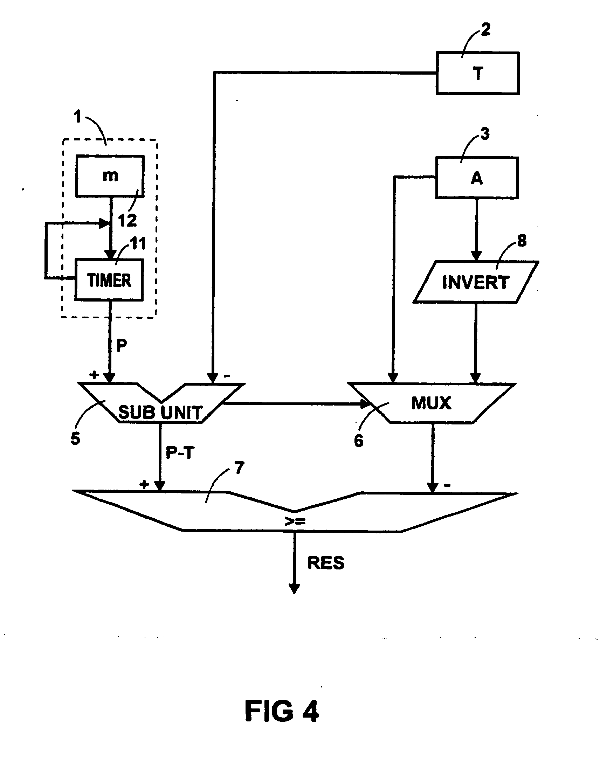

Für den Fall A = B kann die Anordnung gemäß. Figur 3 gleichwertig durch die in der Figur 4 gezeigte Anordnung ersetzt werden.

Die Anordnung gemäß Figur 4 enthält keine Speichereinrichtung 4 zum Speichern des Parameters -B. Statt dessen ist ein Inverter 8 vorgesehen, welcher den Inhalt A der Speichereinrichtung 3 in -B umwandelt.

Das Ergebnis der Invertierung (-B) wird dem Multiplexer 6 zugeführt. Dem Multiplexer 6 der Anordnung gemäß Figur 4 werden damit für den Fall A = B die selben Daten zugeführt wie dem Multiplexer 6 der Anordnung gemäß Figur 3.

Im übrigen stimmen die Anordnungen gemäß Figur 3 und 4 überein; mit den selben Bezugszeichen bezeichnete Elemente entsprechen einander.

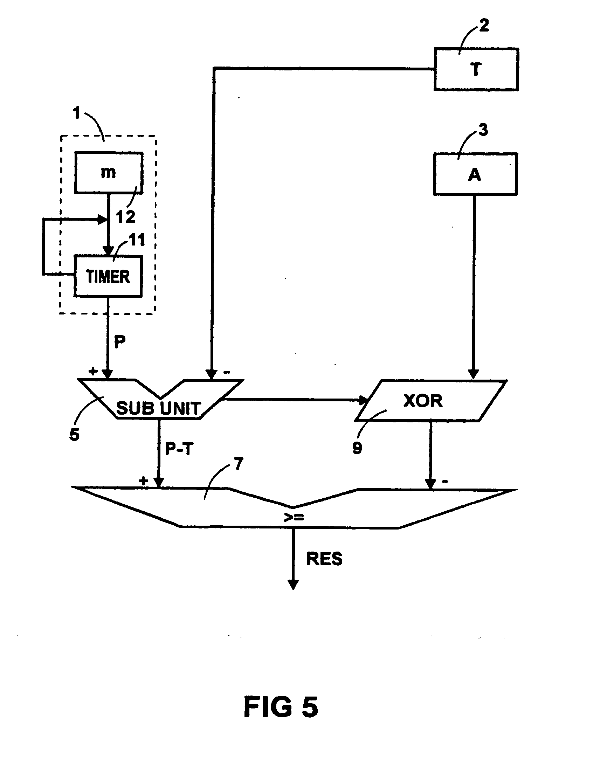

Für den Fall B = A - 1 kann die Anordnung gemäß Figur 3 durch die in der Figur 5 gezeigte Anordnung gleichwertig ersetzt werden.

Die Anordnung gemäß Figur 5 enthält keine Speichereinrichtung 4 zum Speichern des Parameters -B und auch keinen Multiplexer 6. Statt dessen ist eine XOR-Einheit vorgesehen, welche den Inhalt (A) der Speichereinrichtung 3 (einschließlich des Vorzeichenbits) einer bitweisen XOR-Operation mit dem vom Subtrahierer 5 zur XOR-Einheit 9 ausgegebenen Signal unterzieht.

Das vom Subtrahierer 5 zur XOR-Einheit 9 (ein das Vorzeichen des Subtraktionsergebnisses repräsentierendes Bit) sei für Subtraktionsergebnisse ≥ 0 gleich 0, und für Subtraktionsergebnisse < 0 gleich 1.

Eine XOR-Operation, bei welcher einer der der XOR-Operation zu unterziehenden Bits gleich 0 ist, hat den Wert des anderen Bits zum Ergebnis. Für Subtraktionsergebnisse ≥ 0 ist mithin der Inhalt der Speichereinrichtung 3, also A das Ergebnis der XOR-Operation. Anderenfalls ergibt sich -(A - 1), also -B als Ergebnis der XOR-Operation.

Das Ergebnis der XOR-Operation wird dem Multiplexer 6 zugeführt. Dem Multiplexer 6 der Anordnung gemäß Figur 5 werden damit für den Fall B = A - 1 die selben Daten zugeführt wie dem Multiplexer 6 der Anordnung gemäß Figur 3.

Im übrigen stimmen die Anordnungen gemäß Figur 3 und 5 überein; mit den selben Bezugszeichen bezeichneten Elemente entsprechen einander.

Es dürfte einleuchten, daß die Anordnung gemäß Figur 3 ohne Einfluß auf deren Funktion und Wirkungsweise zusätzlich oder anders modifizierbar ist.

Es wird nun unter Bezugnahme auf die Figuren 6 und 7 die eingangs bereits erwähnte zweite Variante einer konfigurierbaren Anordnung zur Ermittlung, ob der Zählstand des Zählers den vorbestimmten Zählstand erreicht hat oder nicht, beschrieben.

Diese Variante ist nicht Gegenstand der Ansprüche.

Bei dieser zweiten Variante werden nur bestimmte Bits des Zählstandes P des Zählers und des vorbestimmten Zählstandes (des Threshold-Wertes T) berücksichtigt. Die berücksichtigten Bits .umfassen das niederwertigste Bit und eine väriierbare Anzahl der nächst höherwertigen Bits der Zählstände.

Eine Anordnung, die eine Variierung der zu berücksichtigenden Bits der einander gegenüberstehenden Zählstände gestattet und in der Lage ist, zu ermitteln, ob der zu berücksichtigende Teil des Zählstandes P des Zählers innerhalb des zu berücksichtigenden Zeitfensters den zu berücksichtigenden Teil des vorbestimmten Zählstandes (des Threshold-Wertes T) erreicht oder passiert hat oder nicht, ist in Figur 6 dargestellt.

Vor der detaillierten Beschreibung der Anordnung gemäß Figur 6 sei angemerkt, daß dort davon ausgegangen wird, daß die einander gegenüberstehenden Zählstände jeweils 24 Bits (Bits 0 ... 23) umfassen, und daß von diesen Bits bei der durch die Anordnung durchzuführende Ermittlung nur jeweils die Bits 0 bis n berücksichtigt werden, wobei n im betrachteten Beispiel zwischen 8 und 23 einstellbar ist.

Wie aus Figur 6 ersichtlich ist, besteht die Anordnung aus einer Vielzahl von Carry-Bit-Erzeugurigsblöcken C, einer Vielzahl von (Ermittlungs-) Resultat-Erzeugungsblöcken R, und einen Multiplexer MUX.....

Die Carry-Bit-Erzeugungsblöcke C sind in einer Anzahl vorhanden, die der Anzahl von Bits entspricht, die die einander gegenüberstehenden Zählstände jeweils umfassen. Pro Zähl= stands-Bit ist ein Carry-Bit-Erzeugungsblock C vorgesehen, im betrachteten Beispiel sind mithin insgesamt 24 Carry-Bit-Erzeugungsblöcke C vorgesehen.

Die Resultat-Erzeugungsblöcke R sind im betrachteten Beispiel in einer geringeren Anzahl vorhanden. Resultat-Erzeugungsblöcke R müssen nämlich nur für diejenigen Bits der Zählstände vorgesehen werden, die das nächst höherwertige Bit nach dem höchstwertigen der zu berücksichtigenden Bits der Zählstände sein können. Im betrachteten Beispiel sind dies die Bits 9 bis 23 der Zählstände; nur für diese Bits sind Resultat-Erzeugungsblöcke R vorgesehen. Die Resultat-Erzeugungsblöcke R sind jeweils dem dem selben Bit zugeordneten Carry-Bit-Erzeugungsblock C nachgeschaltet (siehe Figur 7).

Wie die Bezeichnung schon andeutet, sind die Carry-Bit-Erzeugungsblöcke C zum Erzeugen und Weiterverarbeiten der jeweiligen Carry-Bits vorgesehen, die bei der durchzuführenden Subtraktion P- T entstehen, wobei (wie bei der ersten Variante)

P    den aktuellen Zählstand des Zählers, und

T    den vorbestimmten Zählstand, dessen Erreichen durch den aktuellen Zählstand P ermittelt werden soll (also den Threshold-Wert)

bezeichnen.

Die Carry-Bit-Erzeugungsblöcke C sind im betrachteten Beispiel jeweils Halb-Subtrahierer-Module (zur Subtraktion ausgelegte Halb-Addierer-Module) mit erweiterter (wie bei Voll-Subtrahierern üblicher) Carry-Bit-Erzeugung.

Wie aus Figur 7 ersichtlich ist, enthalten sie jeweils einen Inverter 21, ein XOR-Glied 22, ein erstes UND-Glied 23, ein zweites UND-Glied 24, und ein ODER-Glied 25.

In die Carry-Bit-Erzeugungsblöcke C werden das jeweils zugeordnete Bit des Zählstandes P des Zählers, das jeweils zugeordnete Bit des Threshold-Wertes T, und ein Carry-Bit Carry_In eingegeben, wobei das Carry-Bit Carry_In das Carry-Bit ist, das von dem dem nächst niederwertigen Bit der Zählstände zugeordneten Carry-Bit-Erzeugungsblock C erzeugt wurde.

Dem dem Bit 0 der Zählstände zugeordneten Carry-Bit-Erzeugungsblock C wird - wie bei Subtrahier-Modulen dieser Art üblich - der Wert 1 als Carry_In eingegeben.

Die Carry-Bit-Erzeugungsblöcke C führen die Subtraktion P-Bit - T-Bit aus und erzeugen dabei nach Art eines Halb-Subtrahierers, d.h. ohne Berücksichtigung von Carry_In ein Differenz-Bit Diff_H, und nach Art eines Voll-Subtrahierers, d.h. mit Berücksichtigung von Carry_In ein Carry-Bit Carry_Out, wobei das Differenz-Bit Diff_H den zugeordneten Resultat-Erzeugungsblöcken R (sofern vorhanden) zugeführt wird, und wobei das Carry-Bit Carry_Out an den dem nächst höherwertigen Bit zugeordneten Carry-Bit-Erzeugungsblock C ausgegeben (als Carry-Bit Carry_In in diesen eingegeben) wird.

Das in.dew Carry-Bit-Erzeugungsblock C eingegebene T-Bit wird durch den Inverter 21 invertiert.

Das P-Bit und das invertierte T-Bit werden im XOR-Glied 22 einer XOR-Operation unterzogen. Das Ergebnis dieser XOR-Operation ist das bereits erwähnte Differenz-Bit Diff_H.

Das P-Bit und das invertierte T-Bit werden ferner im ersten UND-Glied 23 einer UND-Operation unterzogen. Das Ergebnis dieser UND-Operation ist das Carry-Bit, das ein Halb-Subtrahierer neben dem Differenz-Bit Diff_H generiert.

Das in den Carry-Bit-Erzeugungsblock C eingegebene Carry-Bit Carry_In und das Differenz-Bit Diff_H werden im zweiten UND-Glied 24 einer UND-Operation unterzogen.

Das Ausgangssignal des zweiten UND-Gliedes 24 und das Ausgarigssignal des ersten UND-Gliedes 23 werden im ODER-Glied 25 einer ODER-Operation unterzogen. Das Ergebnis dieser ODER-Operation ist das bereits erwähnte Carry-Bit Carry_Out.

Die ovrhandenen Resultat-Erzeugungsblöcke E erhalten die vorstehend bereits erwähnten Signale Carry_In und Diff_H als Eingangssignale. Sie unterziehen diese einer XOR-Verknüpfung und generieren dadurch aus dem ohne Berücksichtigung des Carry-Bits Carry_In, also dem durch einen Halb-Subtrahierer erzeugten Differenz-Bit Diff_H ein mit Berücksichtigung des Carry-Bits Carry_In, also ein durch einen Voll-Subtrahierer erzeugtes Differenz-Bit Diff_V.

Das Differenz-Bit Diff_V des dem Bit x der Zählstände zugeordneten Resultat-Erzeugungsblocks R repräsentiert für den Fall, daß von P und T nur die Bits 0 bis x-1 berücksichtigt werden, das Vorzeichen des Ergebnisses der Subtraktion P - T.

Wenn das Differenz-Bit Diff_V gleich 0 ist, ist P - T, genauer gesagt die Differenz der die Bits 0 bis x-1 umfassenden Bestandteile derselben ≥ 0, und wenn das Differenz-Bit Diff_V gleich 1 ist, ist P - T, genauer gesagt die Differenz der die Bits 0 bis x-1 umfassenden Bestandteile derselben < 0. Im erstgenannten Fall, d.h. wenn das Differenz-Bit Diff V gleich null ist, hat der Zählstand P des Zählers (der die Bits 0 bis x-1 umfassende Bestandteil desselben) den Threshold-Wert .T (den die Bits 0 bis x-1 umfassenden Bestandteil desselben) innerhalb des betrachteten Zeitfensters erreicht oder passiert. Anderenfalls; d.h. wenn das Differenz-Bit Diff_V gleich eins ist, hat der Zählstand P des Zählers (der die Bits 0 bis x-1 umfassende Bestandteil desselben) den Threshold-Wert T (den die Bits 0 bis x-1 umfassenden Bestandteil desselben) innerhalb des betrachteten Zeitfensters noch nicht erreicht oder passiert.

Die Ausgangssignale (die Differenz-Bits Diff V) aller Resultat-Erzeugungsblöcke R und das Carry-Bit Carry_Out des den höchstwertigen Bits der Zählstände P und T zugeordneten: Carry-Bit-Erzeugungsblocks C werden dem Multiplexer MUX zugeführt.

Der Multiplexer MUX ist über einen Steueranschluß SCALE steuerbar. Über diesen Steueranschluß ist bestimmbar, welches der an den Multiplexer MUX angelegten Signale durchgeschaltet wird. Dies ist zugleich eine Festlegung der zu berücksichtigenden Bits der Zählstände P und T. Die an den Multiplexer MUX angelegten Signale repräsentieren nämlich die Vorzeichen von unter Berücksichtigung unterschiedlich vieler Bits der Zählstände P und T gebildeten Differenzen P - T.

Wird der Multiplexer MUX so angesteuert, daß dieser das für Bit x der Zählstände ermittelte Differenz-Bit Diff_V durchschaltet, so legt man damit fest, daß bei der Ermittlung; ob der Zählstand P des Zählers den Threshold-Wert T erreicht oder passiert hat oder nicht, von den Zählständen P und T nur die Bits 0 bis x-1 zu berücksichtigen sind, und erhält mit dem vom Multiplexer ausgegebenen Signal RES zugleich das zugeordnete Ermittlungsergebnis.

Die Festlegung der zu berücksichtigenden Bits der Zählstände P und T ist zugleich eine Festlegung der Größe des Zeitfensters, auf das die Ermittlung, ob der Zählstand P des Zählers den Threshold-Wert T erreicht hat oder nicht, beschränkt werden soll.

Die Größe des Zeitfensters ist vorzugsweise gleich der Dauer einer Zählperiode M - m (siehe Figur. 1). Abweichungen nach oben und nach unten erfordern zwar Sonderbehandlungen und gewisse Einschränkungen, sind aber grundsätzlich möglich.

Die Lage des Zeitfensters ist im betrachteten Beispiel - im Gegensatz zu den in den Figuren 3 bis 5 gezeigten Anordnungen - unabhängig von den Zählständen P und T. Sie könnte aber durch eine Veränderung der Zählerparameter m und M verändert werden.

Die vorstehend beschriebene nicht beanspruchte zweite Variante zur Konfigurierung einer Anordnung zum Ermitteln, ob der Zählstand P des Zählers den Threshold-Wert T erreicht hat oder nicht, ist zwar nicht ganz so flexibel einsetzbar wie die erste Variante, aber mit einem erheblich geringeren Aufwand praktisch realisierbar. Der Aufwand zur praktischen Realisierung der zweiten Variante ist nur etwa halb so groß wie der Aufwand zur praktischen Realisierung der ersten Variante.

Unabhängig davon ermöglichen es Anordnungen und Verfahren der vorstehend beschriebenen Art, daß diese mit minimalem Aufwand jederzeit individuell an verschiedene, ja sogar wechselnde Bedürfnisse anpaßbar sind.

**Patentansprüche**

**1.** Anordnung zum Ermitteln, ob der Zählstand (P) eines Zählers (11) einen vorbestimmten Zählstand (T) erreicht hat oder nicht,
**dadurch gekennzeichnet,**
**daß** die Anordnung Mittel enthält,

- durch welche die Differenz (P-T) zwischen dem Zählstand (P) und dem vorbestimmten Zählstand (T) mit einem ersten Wert (A) oder einem negativen zweiten Wert (-B) verglichen wird, wobei die Differenz (P-T) mit dem ersten Wert (A) verglichen wird, wenn die Differenz (P-T) größer oder gleich 0 ist, und wobei die Differenz (P-T) mit dem zweiten Wert (-B) verglichen wird, wenn die Differenz kleiner 0 ist, und
- durch welche signalisiert wird, daß der Zähler (11) den vorbestimmten Zählstand (T) erreicht hat, wenn die Differenz (P-T) kleiner ist als der erste Wert (A) bzw. kleiner ist als der zweite Wert (-B), und durch welche ansonsten signalisiert wird, daß der Zähler (11) den vorbestimmten Zählstand (T) nicht erreicht hat,

wobei der vorbestimmte Zählstand (T) und/oder der erste Wert (A) und/oder der zweite Wert (-B) variierbar sind.

**2.** Anordnung nach Anspruch 1,
**dadurch gekennzeichnet,**
**daß** der Zähler ein periodisch von einem ersten Zählwert (m) bis zu einem zweiten Zählwert (M) zählender Zähler ist, und daß durch den ersten Wert (A) und den zweiten Wert (-B) ein bei der Ermittlung zu berücksichtigendes Zeitfenster (W; A, B) definiert wird.

**3.** Anordnung nach Anspruch 2,
**dadurch gekennzeichnet,**
**daß** sich das Zeitfenster (W; A, B) aus einem vor dem Erreichen des vorbestimmten Zählstandes (T) liegenden Zeitfenster-Bereich (B) und einem nach dem Erreichen des vorbestimmten Zählstandes (T) liegenden Zeitfenster-Bereich (A) zusammensetzt, wobei die Größe des vor dem Erreichen des vorbestimmten Zählstandes (T) liegenden Zeitfenster-Bereiches durch den zweiten Wert (-B) bestimmt wird, und wobei die Größe des nach dem Erreichen des vorbestimmten Zählstandes (T) liegenden Zeitfenster-Bereiches durch den ersten Wert (A) bestimmt wird.

4. Anordnung nach einem der vorhergehenden Ansprüche,
   **dadurch gekennzeichnet,**
   **daß** die Anordnung eine oder mehrere Speichereinrichtungen (3, 4) mit veränderbarem Inhalt zur Speicherung des ersten Wertes (A) und/oder des zweiten Wertes (-B) aufweist.

5. Anordnung nach einem der vorhergehenden Ansprüche,
   **dadurch gekennzeichnet,**
   **daß** die Anordnung eine Speichereinrichtung (2) mit veränderbarem Inhalt zur Speicherung des vorbestimmten Zählstandes (T) aufweist.

6. Verfahren zum Ermitteln, ob der Zählstand (P) eines Zählers (11) einen vorbestimmten Zählstand (T) erreicht hat oder nicht,
   **dadurch gekennzeichnet,**

   - **daß** die Differenz (P-T) zwischen dem Zählstand (P) und dem vorbestimmten Zählstand (T) mit einem ersten Wert (A) oder einem negativen zweiten Wert (-B) verglichen wird, wobei die Differenz (P-T) mit dem ersten Wert (A) verglichen wird, wenn die Differenz (P-T) größer oder gleich 0 ist, und wobei die Differenz (P-T) mit dem zweiten Wert (-B) verglichen wird, wenn die Differenz (P-T) kleiner 0 ist, und
   - **daß** signalisiert wird, daß der Zähler (11) den vorbestimmten Zählstand (T) erreicht hat, wenn die Differenz (P-T) kleiner ist als der erste Wert (A) bzw. kleiner ist als der zweite Wert (-B), und ansonsten signalisiert wird, daß der Zähler (11) den vorbestimmten Zählstand (T) nicht erreicht hat,

   wobei der vorbestimmte Zählstand (T) und/oder der erste Wert (A) und/oder der zweite Wert (-B) variierbar sind.

**Claims**

1. Arrangement for determining whether the counter reading (P) of a counter (11) has reached a predetermined value (T) or not, **characterized in that** the arrangement contains means

   - by which the difference (P-T) between the counter reading (P) and the predetermined counter reading (T) is compared with a first value (A) or a negative second value (-B), the difference (P-T) being compared with the first value (A) if the difference (P-T) is greater than or equal to 0, and the difference (P-T) being compared with the second value (-B) if the difference is less than 0, and
   - which signal that the counter (11) has reached the predetermined counter reading (T) if the difference (P-T) is less than the first value (A) or is less than the second value (-B), and which otherwise signal that the counter (11) has not reached the predetermined counter reading (T),

   the predetermined counter reading (T) and/or the first value (A) and/or the second value (-B) being variable.

2. Arrangement according to Claim 1, **characterized in that** the counter is a counter which counts periodically from a first count (m) up to a second count (M), and **in that** a time window (W; A, B) to be taken into account in the determination is defined by the first value (A) and the second value (-B).

3. Arrangement according to Claim 2, **characterized in that** the time window (W; A, B) is composed of a time window range (B) preceding the reaching of the predetermined counter reading (T) and a time window range (A) succeeding the reaching of the predetermined counter reading (T), the magnitude of the time window range preceding the reaching of the predetermined counter reading (T) being determined by the second value (-B), and the magnitude of the time window range succeeding the reaching of the predetermined counter reading (T) being determined by the first value (A).

4. Arrangement according to one of the preceding claims, **characterized in that** the arrangement has one or more storage devices (3, 4) with a variable content for storing the first value (A) and/or the second value (-B).

5. Arrangement according to one of the preceding claims, **characterized in that** the arrangement has a storage device (2) with a variable content for storing the predetermined counter reading (T).

6. Method for determining whether the counter reading (P) of a counter (11) has reached a predetermined value (T) or not, **characterized**

- **in that** the difference (P-T) between the counter reading (P) and the predetermined counter reading (T) is compared with a first value (A) or a negative second value (-B), the difference (P-T) being compared with the first value (A) if the difference (P-T) is greater than or equal to 0, and the difference (P-T) being compared with the second value (-B) if the difference (P-T) is less than 0, and
- **in that** it is signalled that the counter (11) has reached the predetermined counter reading (T) if the difference (P-T) is less than the first value (A) or is less than the second value (-B), and it is otherwise signalled that the counter (11) has not reached the predetermined counter reading (T),

the predetermined counter reading (T) and/or the first value (A) and/or the second value (-B) being variable.

## Revendications

1. Arrangement destiné à déterminer si la valeur comptée (P) d'un compteur (11) a atteint ou non une valeur comptée prédéterminée (T), **caractérisé en ce que** l'arrangement contient des moyens

- par le biais desquels la différence (P-T) entre la valeur comptée (P) et la valeur comptée prédéterminée (T) est comparée avec une première valeur (A) ou une deuxième valeur négative (-B), la différence (P-T) étant comparée avec la première valeur (A) lorsque la différence (P-T) est supérieure ou égale à 0 et la différence (P-T) étant comparée avec la deuxième valeur (-B) lorsque la différence est inférieure à 0, et
- par le biais desquels il est signalé que le compteur (11) a atteint la valeur comptée prédéterminée (T) lorsque la différence (P-T) est inférieure à la première valeur (A) ou inférieure à la deuxième valeur (-B) et par le biais desquels il est sinon signalé que le compteur (11) n'a pas atteint la valeur comptée prédéterminée (T),

la valeur comptée prédéterminée (T) et/ou la première valeur (A) et/ou la deuxième valeur (-B) étant variables.

2. Arrangement selon la revendication 1, **caractérisé en ce que** le compteur est un compteur qui compte périodiquement d'une première valeur comptée (m) à une deuxième valeur comptée (M) et **en ce qu'**un créneau temporel (W ; A ; B) à prendre en compte lors de la détermination est défini par la première valeur (A) et la deuxième valeur (-B).

3. Arrangement selon la revendication 2, **caractérisé en ce que** le créneau temporel (W ; A ; B) se compose d'une plage de créneau temporel (B) qui se situe avant le moment d'atteindre la valeur comptée prédéterminée (T) et d'une plage de créneau temporel (A) qui se situe après le moment d'atteindre la valeur comptée prédéterminée (T), la taille de la plage de créneau temporel qui se situe avant le moment d'atteindre la valeur comptée prédéterminée (T) étant déterminée par la deuxième valeur (-B) et la taille de la plage de créneau temporel qui se situe après le moment d'atteindre la valeur comptée prédéterminée (T) étant déterminée par la première valeur (A).

4. Arrangement selon l'une des revendications précédentes, **caractérisé en ce que** l'arrangement présente un ou plusieurs dispositifs de mémorisation (3, 4) dont le contenu peut être modifié pour enregistrer la première valeur (A) et/ou la deuxième valeur (-B).

5. Arrangement selon l'une des revendications précédentes, **caractérisé en ce que** l'arrangement présente un dispositif de mémorisation (2) dont le contenu peut être modifié pour enregistrer la valeur comptée prédéterminée (T).

6. Procédé destiné à déterminer si la valeur comptée (P) d'un compteur (11) a atteint ou non une valeur comptée prédéterminée (T), **caractérisé en ce**

- **que** la différence (P-T) entre la valeur comptée (P) et la valeur comptée prédéterminée (T) est comparée avec une première valeur (A) ou une deuxième valeur négative (-B), la différence (P-T) étant comparée avec la première valeur (A) lorsque la différence (P-T) est supérieure ou égale à 0 et la différence (P-T) étant comparée avec la deuxième valeur (-B) lorsque la différence (P-T) est inférieure à 0, et
- **qu'**il est signalé que le compteur (11) a atteint la valeur comptée prédéterminée (T) lorsque la différence (P-T) est inférieure à la première valeur (A) ou inférieure à la deuxième valeur (-B) et il est sinon signalé que le compteur (11) n'a pas atteint la valeur comptée prédéterminée (T),

la valeur comptée prédéterminée (T) et/ou la première valeur (A) et/ou la deuxième valeur (-B) étant variables.

**FIG 1**

Zählstand

**FIG 2A**

Zählstand

**FIG 2B**

Zählstand

**FIG 2C**

Zeit

**FIG 3**

**FIG 4**

**FIG 5**

FIG 6

**FIG 7**